(19) Europäisches Patentamt
European Patent Office
Office européen des brevets

(11) **EP 1 507 888 B1**

(12) **EUROPÄISCHE PATENTSCHRIFT**

(45) Veröffentlichungstag und Bekanntmachung des Hinweises auf die Patenterteilung:
**22.12.2010 Patentblatt 2010/51**

(21) Anmeldenummer: **03755893.9**

(22) Anmeldetag: **14.05.2003**

(51) Int Cl.:
***C23C 16/34*** *(2006.01)*

(86) Internationale Anmeldenummer:
**PCT/DE2003/001552**

(87) Internationale Veröffentlichungsnummer:
**WO 2003/102264 (11.12.2003 Gazette 2003/50)**

(54) **PLASMAANGEREGTES CHEMISCHES GASPHASENABSCHEIDE-VERFAHREN ZUM ABSCHEIDEN VON SILIZIUMNITRID ODER SILIZIUMOXINITRID IN EINEM MIM-KONDENSATOR**

PLASMA-ENHANCED CHEMICAL VAPOUR DEPOSITION METHOD FOR DEPOSITING SILICON NITRIDE OR SILICON OXYNITRID IN AN MIM-CAPACITOR

PROCEDE DE DEPOT CHIMIQUE EN PHASE VAPEUR ASSISTE PAR PLASMA DE NITRURE DE SILICIUM OU D'OXYNITRURE DE SILICIUM POUR CONDENSATEUR MIM.

(84) Benannte Vertragsstaaten:
**DE FR**

(30) Priorität: **29.05.2002 DE 10223954**

(43) Veröffentlichungstag der Anmeldung:
**23.02.2005 Patentblatt 2005/08**

(73) Patentinhaber: **Infineon Technologies AG
85579 Neubiberg (DE)**

(72) Erfinder: **VOGT, Mirko
01307 Dresden (DE)**

(74) Vertreter: **Dokter, Eric-Michael
Viering, Jentschura & Partner
Postfach 22 14 43
80504 München (DE)**

(56) Entgegenhaltungen:
EP-A- 0 454 100    US-A1- 2001 044 220
US-B1- 6 171 978    US-B1- 6 221 794

• **ODEKIRK B ET AL: "Plasma CVD silicon nitride on-chip capacitors for GaAs IC fabrication" PROCEEDINGS OF THE SYMPOSIUM ON DIELECTRIC FILMS ON COMPOUND SEMICONDUCTORS, LAS VEGAS, NV, USA, 14-17 OCT. 1985, Seiten 274-286, XP008025865 1986, Pennington, NJ, USA, Electrochem. Soc, USA**

**Beschreibung**

Die Erfindung betrifft ein Verfahren zum Herstellen eines MIM-Kondensators gemäß Anspruch 1, bzw Anspruch 8.

Metall-Isolator-Metall-Kondensatoren (MIM-Kondensatoren) sind in der Regel aus einer ersten metallischen Schicht auf einem Substrat, einer auf der ersten metallischen Schicht angeordneten dielektrischen Schicht und einer auf der dielektrischen Schicht angeordneten zweiten metallischen Schicht aufgebaut. Die drei Schichten eines MIM-Kondensators werden mit halbleitertechnologischen Verfahren auf die Substrat-Oberfläche aufgebracht.

Ein MIM-Kondensator ist für eine Reihe technischer Anwendungen interessant. So kann ein MIM-Kondensatoren in einem Radiofrequenz-Schaltkreis (RF-Schaltkreis), in einem analogen integrierten Schaltkreis oder in einem Hochleistungsmikroprozessor (MPUs) verwendet werden. Ferner besteht eine wirtschaftlich interessante Anwendung eines MIM-Kondensators darin, dass er als Speicherkondensator in einem DRAM-Speicher ("Dynamic Random Access Memory") verwendet werden kann. Ferner ist es möglich, einen MIM-Kondensator in einer Flüssigkristallanzeige (LCD) zu verwenden. Auch in einem Logik-Schaltkreis findet eine MIM-Kapazität verstärkt Anwendung.

Eine wichtige Anforderung an einen MIM-Kondensator ist, dass dessen Kapazität C ausreichend groß ist. Die Kapazität eines Plattenkondensators berechnet sich gemäß der Beziehung

$$C = \varepsilon A/d \qquad (1)$$

Dabei ist $\varepsilon$ ist die relative Dielektrizitätskonstante des zwischen den Kondensatorplatten eingebrachten Mediums, A ist die Fläche einer Platte des Plattenkondensators und d ist der Plattenabstand zwischen den beiden Platten des Kondensators.

Um eine ausreichend große Kapazität zu erreichen, kann die Fläche des Kondensators A entsprechend ausreichend groß gewählt werden. Es ist allerdings ein bedeutendes Ziel der Silizium-Mikroelektronik, zunehmend kleinere Strukturen zu entwickeln. Daher ist das Erreichen einer ausreichend hohen Kapazität eines MIM-Kondensators mittels Erhöhens der Plattenfläche des Kondensators mit dem Ziel einer fortschreitenden Miniaturisierung von integrierten Schaltkreisen nicht kompatibel. Ferner kann, wie sich aus Gleichung (1) ergibt, der Abstand zwischen den beiden Platten, d.h. die Dicke d der dielelektrischen Schicht zwischen den beiden metallischen Schichten des MIM-Kondensators, ausreichend klein gewählt werden. Sofern die Schichtdicke eines MIM-Kondensators eine Dimension von etwa 50nm unterschreitet, treten Probleme hinsichtlich dessen elektrischer Stabilität auf, beispielsweise können elektrische Durchbrüche auftreten, und elektrische Leckströme können zunehmen.

Daher ist es erstrebenswert, dass die Dielelektrizitätskonstante der dielektrischen Schicht zwischen den beiden metallischen Schichten eines MIM-Kondensators möglichst hoch ist.

Gemäß dem Stand der Technik wird als Material für die dielektrische Schicht eines MIM-Kondensators häufig stöchiometrisches Siliziumnitrid ($Si_3N_4$) oder stöchiometrisches Siliziumoxid, d.h. Siliziumdioxid ($SiO_2$), verwendet. Siliziumnitrid weist die Eigenschaft auf, dass die Dielektrizitätskonstante ($\varepsilon$=6-7) vorteilhaft hoch ist. Allerdings weisen Siliziumnitrid-Schichten verwendet als dielektrische Schichten eines MIM-Kondensators den Nachteil auf, dass die elektrische Durchbruchfeldstärke relativ gering ist (ungefähr 2MV/cm). Dagegen ist die Durchbruchfeldstärke von Siliziumdioxid vorteilhafterweise deutlich größer als bei Siliziumnitrid (ungefähr 6MV/cm), aber die relative Dielektrizitätskonstante von Siliziumdioxid ($\varepsilon$=4) ist deutlich geringer als die von Siliziumnitrid.

Das Ausbilden einer dielektrischen Schicht eines MIM-Kondensators erfolgt gemäß dem Stand der Technik beispielsweise mittels thermischen Aufwachsens oder gemäß dem CVD-Verfahren ("Chemical Vapour Deposition").

Das CVD-Verfahren ist eine Beschichtungstechnologie zum Abscheiden dünner Schichten aus der Gasphase auf einem festen Substrat. Das Prinzip des CVD-Verfahrens besteht darin, dass gasförmige Ausgangsmaterialien, sogenannte Precursoren, über ein Substrat geleitet und chemisch in deren Bestandteile zerlegt werden, wodurch auf der Substrat-Oberfläche eine neue Schicht aufwächst. Das Zerlegen der Precursoren erfolgt zumeist thermisch, d.h. mittels Heizens des Substrats. Das eigentliche Abscheiden erfolgt unter Beteiligung einer chemischen Reaktion, beispielsweise reagiert eine flüchtige gasförmige Komponente mit einem anderen Gas zu einem festen Material, das auf dem Substrat abgeschieden wird. Allerdings weist das CVD-Verfahren den Nachteil auf, dass die Prozesstemperaturen relativ hoch sind.

Ein Ausweg aus der Verwendung der hohen Prozesstemperaturen bietet das Plasmaangeregte chemische Gasphasenabscheide-Verfahren (PECVD, "Plasma Enhanced Chemical Vapour Deposition"). Während bei herkömmlichen CVD-Prozessen die Gasphasenreaktion durch thermische Energie infolge Heizens des Substrats ausgelöst wird, beruht das PECVD-Verfahren auf der Überführung eines Gases in den Plasma-Zustand in der Nähe der Substrat-Oberfläche. Eines der Reaktionsprodukte ist dabei ein fester Stoff, der sich auf der Oberfläche niederschlägt, wodurch eine neue Schicht gebildet wird. Unter Verwendung des PECVD-Verfahrens lassen sich unter anderem Siliziumnitrid

$(SiN_x)$, Siliziumoxid $(SiO_x)$ und Siliziumoxinitrid $(SiO_yN_z)$ abscheiden. In einem PECVD-Reaktor wird zwischen dem Substrat-Halter, der als Elektrode dient und einer weiteren Elektrode durch ein starkes elektrisches Wechselfeld ein Plasma gezündet. Durch die Energie des Feldes werden Bindungen der in den PECVD-Reaktor eingeleiteten Gasmoleküle aufgebrochen und die Gasmoleküle zersetzt. Die entstehenden Radikale können mittels eines optionalen zweiten elektrischen Feldes in Richtung des Substrats bewegt werden, wo sich die hochreaktiven Radikale niederschlagen und die gewünschte Schicht bilden.

Aus dem Stand der Technik sind Verfahren bekannt, bei denen unter Verwendung des PECVD-Verfahrens dielektrische Schichten aus Siliziumoxid, Siliziumnitrid oder Siliziumoxinitrid erzeugt werden. Allerdings weisen derartige Schichten häufig keine ausreichend große relative Dielelektrizitätskonstante auf. Ferner weisen die aus dem Stand der Technik bekannten, mittels des PECVD-Verfahrens hergestellten dielektrischen Schichten häufig keine ausreichende mechanische bzw. elektrische Stabilität auf. MIM-Kapazitäten mit ausreichend hohen Kapazitäten sind gemäß dem aus dem Stand der Technik bekannten Verfahren daher nur erzeugbar, wenn der Abstand zwischen den metallischen Schichten eines MIM-Kondensators ausreichend klein gewählt wird. In diesem Falle kann es allerdings leicht zu unerwünschten elektrischen Durchbrüchen zwischen den beiden metallischen Schichten kommen.

[1] offenbart eine Schicht-Anordnung zum Herstellen einer Isolationsstruktur.

[2] offenbart ein Verfahren zum Herstellen eines Siliziumnitrid-Films, der für UV-Strahlung durchlässig ist.

[3] offenbart eine mittels PECVD herstellbare Siliziumnitrid-Schicht als Passivierungsschicht.

[4] offenbart ein Verfahren zum Herstellen von Siliziumoxinitrid-Filmen.

[5] offenbart ein Verfahren zum Herstellen eines Siliziumnitrid-Films als Gate-Dielektrikum.

[6] offenbart das Herstellen elekronischer Vorrichtungen, die MIMs und TFTs aufweisen.

[7] offenbart das Herstellen von Siliziumoxinitrid als Deckschicht einer Mikrostruktur.

[8] offenbart ein Verfahren zum Herstellen einer Kombination von Hartmaske und Antireflexschicht.

[9] offenbart ein Verfahren und eine Vorrichtung zum Auftragen von Filmen unter Verwendung reduzierter Abscheideraten.

[10] offenbart ein Verfahren zum Ausbilden Silizium-basierter Dünnfilme.

[11] offenbart ein plasmaangeregtes chemisches Gasphasenabscheide-Verfahren zum Abscheiden von Siliziumnitrid als dielektrische Schicht eines MIM-Kondensators. [12] offenbart ein plasmaangeregtes chemisches Gasphasenabscheide-Verfahren zum Herstellen von Siliziumoxinitrid-Schichten.

Der Erfindung liegt das Problem zugrunde, eine dielektrische Schicht bereitzustellen, die eine größere relative Dielektrizitätskonstante aufweist bei im Wesentlichen gleichbleibender mechanischer und elektrischer Stabilität.

Das Problem wird durch ein Vefahren zum Herstellen eines MIM-Kondensators gemäß Anspruch 1, bzw. Anspruch 8.

Bei dem erfindungsgemäßen Plasmaangeregten chemischen Gasphasenabscheide-Verfahren gemäß Anspruch 1 zum Abscheiden von Siliziumnitrid auf einem Substrat werden Silan, Ammoniak und Stickstoff als Precursoren verwendet, das Flussratenverhältnis von Silan zu Ammoniak wird zwischen 1:20 und 6:5 eingestellt, das Flussratenverhältnis zwischen Silan und Stickstoff wird zwischen 1:40 und 3:5 eingestellt und der Druck in der Verfahrenskammer wird zwischen 260 Pa and 530 Pa eingestellt.

Bei dem Plasmaangeregten chemischen Gasphasenabscheide-Verfahren gemäß Anspruch 8 zum Abscheiden von Siliziumoxinitrid auf einem Substrat werden Silan, Distickstoffmonoxid und Stickstoff als Precursoren verwendet. Das Flussratenverhältnis von Silan zu Distickstoffmonoxid wird zwischen 1:2 und 25:4 eingestellt und das Flussratenverhältnis zwischen Silan und Stickstoff wird zwischen 1:100 und 1:10 eingestellt.

Bei den genannten Flussraten, angegeben in Standardkubikzentimetern pro Minute (sccm), handelt es sich um Massenflüsse.

Die erfindungsgemäß gewählten Flussraten-Verhältnisse der Precursoren des PECVD-Verfahrens zum Herstellen einer Siliziumnitrid-Schicht bzw. einer Siliziumoxinitrid-Schicht unterscheiden sich anschaulich vom Stand der Technik dadurch, dass im Falle des Abscheidens von Siliziumnitrid das Verhältnis der Flussraten von Silan $(SiH_4)$ zu

Ammoniak ($NH_3$) bzw. beim Abscheiden von Siliziumoxinitrid das Verhältnis der Flussraten von Silan zu Distickstoff-monoxid ($N_2O$) erhöht sind. Die erfindungsgemäß hergestellten Schichten aus Siliziumnitrid ($SiN_x$) bzw. Siliziumoxinitrid ($SiO_yN_z$) weisen dabei vorzugsweise nicht-stöchiometrische Silizium-Anteile auf. D.h., dass beispielsweise die erfindungsgemäß hergestellten Siliziumnitrid-Schichten einen höheren Silizium-Anteil aufweisen können als stöchiometrisches Siliziumnitrid ($Si_3N_4$), das 3/7 Atomanteile Silizium aufweist. Da Silizium eine hohe Dielektrizitätskonstante aufweist ($\varepsilon$=12), ist dadurch die Dielektrizitätskonstante der erfindungsgemäß hergestellten Siliziumnitrid- bzw. Siliziumoxinitrid-Schichten erhöht.

Indem erfindungsgemäß ein Verfahren bereitgestellt ist, gemäß dem das Abscheiden einer dielektrischen Schicht aus Siliziumnitrid bzw. aus Siliziumoxinitrid mit gegenüber dem Stand der Technik erhöhter Dielektrizitätskonstante ermöglicht ist, ist eine solche Schicht dazu geeignet, als dielektrische Schicht eines MIM-Kondensators verwendet zu werden. Bezugnehmend auf Gleichung (1) kann mit einer solchen Schicht bei einer kleineren Fläche der beiden metallischen Deckschichten des MIM-Kondensators ein Kondensator mit der gleichen Kapazität C hergestellt werden. Umgekehrt ist es möglich, bei Verwendung der erfindungsgemäß hergestellten Siliziumnitrid- bzw. Siliziumoxinitrid-Schicht als dielektrische Schicht eines MIM-Kondensators die Dicke der dielektrischen Schicht und damit den Abstand d zwischen den beiden metallischen Deckschichten bei gleicher Kapazität größer zu wählen, so dass eine höhere mechanische und elektrische Stabilität des MIM-Kondensators erreicht wird. Insbesondere sind bei einer höheren dielektrischen Schichtdicke in einem MIM-Kondensator Probleme mit elektrischen Leckströmen zwischen den metallischen Schichten vermieden und elektrische Durchbrüche bei hohen elektrischen Feldern ebenfalls vermieden.

Ferner zeigen Experimente an den erfindungsgemäß hergestellten Siliziumnitrid- bzw. Siliziumoxinitrid-Schichten, dass diese Schichten mit einem hohen Silizium-Anteil verringerte Druckspannungen (d.h. mechanische Eigenspannungen) und eine verringerte Nassätzrate aufweisen. Eine ausreichend geringe Nassätzrate ist von Vorteil, da dies ein Entfernen bzw. Rückätzen einer solchen Schicht unter kontrollierten Prozessbedingungen ermöglicht.

Ferner beruht das erfindungsgemäße Verfahren auf dem halbleitertechnologischen Standardverfahren PECVD, wie es auf kommerziell erwerbbaren PECVD-Reaktoren, beispielsweise dem "Novellus Concept One", durchgeführt werden kann. Daher ist das Herstellen der erfindungsgemäßen Silizium-reichen Siliziumnitrid- bzw. Siliziumoxinitrid-Schichten mit einem mäßigen Aufwand möglich.

Bevorzugte Weiterbildungen ergeben sich aus den abhängigen Ansprüchen.

Das Erzeugen des Plasmas aus den in den Verfahrensraum eingeleiteten Precursoren Silan, Ammoniak und Stickstoff erfolgt vorzugsweise mittels eines Hochfrequenz-Feldes mit einer Leistung zwischen ungefähr 300W und 700W.

Optional kann ein Niederfrequenz-Feld mit einer Leistung zwischen ungefähr 300W und 700W an das Substrat angelegt werden, um Plasma in einem Umgebungsbereich des Substrats zu akkumulieren.

Gemäß einer bevorzugten Weiterbildung wird die Flussrate von Silan auf einen Wert zwischen 100 Standardkubikzentimeter pro Minute und 600 Standardkubikzentimeter pro Minute eingestellt.

Vorzugsweise wird bei dem Verfahren das Flussratenverhältnis von Silan zu Ammoniak zwischen 1:10 und 3:5 eingestellt, das Flussratenverhältnis zwischen Silan und Stickstoff zwischen 1:20 und 3:20, der Druck in der Verfahrenskammer zwischen 360Pa und 430Pa und die Leistung des Hochfrequenz-Feldes sowie die Leistung des Niederfrequenz-Feldes voneinander unabhängig jeweils auf einen Wert zwischen ungefähr 400W und 600W.

Sehr gute Ergebnisse werden erreicht, wenn bei dem Verfahren das Flussratenverhältnis von Silan zu Ammoniak auf ungefähr 3:10 eingestellt wird, das Flussratenverhältnis zwischen Silan und Stickstoff auf ungefähr 3:16 eingestellt sein, der Druck in der Verfahrenskammer auf ungefähr 350Pa eingestellt wird und die Hochfrequenz-Leistung und die Niederfrequenz-Leistung auf jeweils ungefähr 500W eingestellt werden.

Die Flussrate von Silan kann gemäß dieser Weiterbildung auf ungefähr 300 Standardkubikzentimeter pro Minute eingestellt werden.

Bezugnehmend auf das Plasmaangeregte chemische Gasphasenabscheide-Verfahren zum Abscheiden von Siliziumoxinitrid auf einem Substrat wird der Druck in der Verfahrenskammer vorzugsweise zwischen 260Pa und 530Pa eingestellt.

Darüber hinaus kann ein Hochfrequenz-Feld mit einer Leistung zwischen 200W und 500W zum Erzeugen des Plasmas angelegt werden.

Darüber hinaus kann ein Niederfrequenz-Feld mit einer Leistung von bis zu 300W zum Akkumulieren von Plasma in einem Umgebungsbereich des Substrats angelegt werden. Das Niederfrequenz-Feld ist jedoch nicht unbedingt erforderlich und kann optional weggelassen werden.

Die Flussrate von Silan wird vorzugsweise auf einen Wert zwischen 100 und 500 Standardkubikzentimeter pro Minute eingestellt.

Gemäß einer günstigen Konfiguration des erfindungsgemäßen Verfahrens zum Abscheiden von Siliziumoxinitrid auf einem Substrat wird das Flussratenverhältnis von Silan zu Distickstoffmonoxid zwischen 1:1 und 25:8 eingestellt, das Flussratenverhältnis zwischen Silan und Stickstoff zwischen 1:50 und 1:20 eingestellt, der Druck in der Verfahrenskammer zwischen 350Pa und 430Pa eingestellt und die Leistung des Hochfrequenz-Feldes auf einen Wert zwischen 300W und 400W sowie die Leistung des Niederfrequenz-Feldes auf einen Wert von bis zu 150W eingestellt. Das Niederfrequenz-Feld kann jedoch auch weggelassen werden.

Besonders günstige Ergebnisse werden erhalten, wenn bei dem erfindungsgemäßen Verfahren zum Abscheiden einer Siliziumoxinitrid-Schicht das Flussratenverhältnis von Silan zu Distickstoffmonoxid auf ungefähr 13:12 eingestellt wird, das Flussratenverhältnis zwischen Silan und Stickstoff auf ungefähr 13:800 eingestellt wird, der Druck in der Verfahrenskammer auf ungefähr 350Pa eingestellt wird und die Leistung des Hochfrequenz-Feldes auf ungefähr 300W eingestellt wird.

Vorzugsweise wird in diesem Fall die Flussrate von Silan auf ungefähr 130 Standardkubikzentimeter pro Minute eingestellt.

Als Substrat wird vorzugsweise ein Halbleiter-Substrat verwendet, beispielsweise ein Silizium-Substrat wie ein Silizium-Wafer oder ein Silizium-Chip.

Hinsichtlich des oben beschriebenen Verfahrens zum Herstellen einer Schicht-Anordnung mit den oben beschriebenen Merkmalen wird für das erste und/oder für das zweite elektrisch leitfähige Material ein Metall verwendet.

Die verfahrensgemäß hergestellte Schicht-Anordnung wird vorzugsweise als MIM-Kondensator verwendet.

Bei dem Ausbilden einer elektrisch isolierenden Schicht, beispielsweise gemäß den erfindungsgemäßen Verfahren, kann die Gefahr bestehen, dass aufgrund von Schwankungen in der Prozessführung und/oder aufgrund anderer unerwünschter Effekte die elektrisch isolierende Eigenschaft einer ausgebildeten Schicht, beispielsweise einer Siliziumoxid- bzw. Siliziumoxinitrid-Schicht, nicht in idealer Weise erreicht wird. Eine solche Schicht kann unerwünschterweise eine gewisse elektrische Rest-Leitfähigkeit haben. Um dies zu vermeiden, sind erfindungsgemäß die im Weiteren beschriebenen Verfahren bereitgestellt, mit denen die elektrisch isolierende Eigenschaft einer Schicht, beispielsweise einer erfindungsgemäß hergestellten Siliziumoxid- oder Siliziumoxinitrid-Schicht, verbessert werden können.

Gemäß einem ersten Verfahren zum Verbessern der elektrisch isolierenden Eigenschaft einer abzuscheidenden, elektrisch isolierenden Schicht, beispielsweise einer Siliziumoxinitrid- bzw. Siliziumoxid-Schicht, wird das Abscheideverfahren mindestens einmal unterbrochen und nach einer vorgebaren Wartezeit fortgesetzt, so dass die elektrisch isolierende Schicht aus $n+1$ Teilschichten ausgebildet wird, wobei $n$ die Anzahl der Unterbrechungen ist. Bezogen auf das oben beschriebene erfindungsgemäße plasmaangeregte chemische Gasphasen-Abscheideverfahren zum Abscheiden von Siliziumoxinitrid- bzw. Siliziumoxid auf einem Substrat wird der plasmagestützte Abscheideprozess einmal oder mehrfach unterbrochen und jeweils nach einer Wartezeit fortgesetzt. Infolge des kurzzeitigen Abschaltens des Plasmas bzw. des Unterbrechens des Abscheide-Prozesses kann somit das sukzessive Ausbilden der Schicht unterbrochen werden. Daher entsteht anschaulich ein Schichtstapel aus mehreren Teilschichten (welche allerdings im Wesentlichen aus demselben Material hergestellt sind), wobei an den Grenzflächen zweier benachbarter Teilschichten infolge der Unterbrechung des Prozesses vorteilhafterweise häufig Defekte, d.h. Festkörperfehlordnungen (z.B. Versetzungen), auftreten können. Anschaulich unterbrechen diese Festkörperfehler mögliche in der Schicht enthaltene durchgehende elektrisch leitfähige Bereiche und unterbinden daher parasitäre Strompfade. Eine auf diese Weise erhaltene heterogene elektrisch isolierende Schicht weist gegenüber einer ohne Unterbrechen des Abscheideverfahrens abgeschiedenen Schicht eine verbesserte Isolationswirkung auf. Elektrische Durchbrüche und Leckströme sind somit vermieden.

Zusammenfassend ist ein Verfahren zum Abscheiden einer annähernd elektrisch isolierenden Schicht mit verringerter Rest-Leitfähigkeit, vorzugsweise einer Siliziumoxid- oder Siliziumoxinitrid-Schicht, geschaffen, wobei gemäß dem Verfahren - die Schicht in mindestens zwei Teilschritten unter Verwendung eines vorgegebenen Abscheideverfahrens, vorzugsweise eines plasmagestützten Abscheideverfahrens, abgeschieden wird

- zwischen jeweils zwei Teilschritten das Abscheiden für eine jeweils vorgebbare Zeitdauer unterbrochen wird.

Gemäß einem zweiten Verfahren, das ergänzend oder alternativ zu dem zuvor beschriebenen Verfahren angewendet werden kann, wird die elektrische Isolations-Eigenschaft einer erfindungsgemäß herzustellenden annähernd elektrisch isolierenden Schicht, beispielsweise einer Siliziumoxid- bzw. Siliziumoxinitrid-Schicht, dadurch verbessert, dass möglicherweise in einer abgeschiedenen Schicht enthaltende elektrisch leitfähige Bereiche, beispielsweise ungesättigte Silizium-Bindungen in einer Siliziumoxid-Schicht, in einem sauerstoffhaltigen Plasma oxidiert und somit abgesättigt werden. Mit anderen Worten kann beipielsweise nach einer Teilabscheidung oder einer Gesamtabscheidung einer Siliziumoxid- bzw. Siliziumoxinitrid-Schicht eine Oberflächenbehandlung in einem sauerstoffhaltigen Plasma (beispielsweise einem Sauerstoff-Plasma und/oder einem Distickstoffmonoxid-Plasma) durchgeführt werden. An der Oberfläche einer Gesamtschicht bzw. Teilschicht befindliche zuvor nicht abgesättigte Silizium-Bindungen werden dadurch oxidiert, wodurch die Rest-Leitfähigkeit der ausgebildeten Schicht verringert wird und gegebenenfalls leitfähige Pfade für Leckströme eliminiert oder zumindest unterbrochen werden.

Zusammenfassend ist ein Verfahren zum Abscheiden einer annähernd elektrisch isolierenden Schicht mit verringerter Rest-Leitfähigkeit, vorzugsweise einer Siliziumoxid- oder Siliziumoxinitrid-Schicht, geschaffen, wobei gemäß dem Verfahren

- die Schicht unter Verwendung eines vorgegebenen Abscheideverfahrens, vorzugsweise eines plasmagestützten Abscheideverfahrens, abgeschieden wird
- die Schicht einem sauerstoffhaltigen Plasma derart ausgesetzt wird, dass elektrisch leitfähige Bereiche der Schicht infolge einer Wechselwirkung mit dem sauerstoffhaltigen Plasma in elektrisch isolierende Bereiche umgewandelt werden.

Ausführungsbeispiele der Erfindung sind in den Figuren dargestellt und werden im Weiteren näher erläutert.

Es zeigen:

Figur 1 einen PECVD-Reaktor, mittels dem das Verfahren zum Abscheiden einer Siliziumnitrid-Schicht bzw. einer Siliziumoxinitrid-Schicht gemäß einem bevorzugten Ausführungsbeispiel der Erfindung durchgeführt werden kann,

Figur 2 ein unter Verwendung einer Infrarotspektroskopie-Methode (FTIR) ermitteltes Diagramm, das schematisch die Abhängigkeit der Infrarotabsorption I von der Wellenzahl k der Infrarotstrahlung für erfindungsgemäß hergestellte Siliziumnitrid-Schichten für unterschiedliche Ammoniak-Flussraten zeigt,

Figur 3 ein unter Verwendung einer Infrarotspektroskopie-Methode (FTIR) ermitteltes Diagramm, das schematisch die Abhängigkeit der Infrarotabsorption I von der Wellenzahl k der Infrarotstrahlung für erfindungsgemäß hergestellte Siliziumoxinitrid-Schichten für unterschiedliche Distickstoffmonoxid-Flussraten zeigt,

Figur 4 ein Diagramm, das Ergebnisse aus Rutherford-Rückstreu-Experimenten (RBS) zeigt, und in dem die Abhängigkeit der Konzentration von Silizium, Sauerstoff und Stickstoff erfindungsgemäß hergestellter Siliziumoxinitrid-Schichten in Abhängigkeit der Flussrate von Distickstoffmonoxid gezeigt sind,

Figur 5A ein Diagramm, das schematisch die Abhängigkeit der relativen Dielektrizitätskonstante $\varepsilon$ vom Brechungsindex n für eine erfindungsgemäß hergestellte Siliziumnitrid-Schicht bzw. für eine erfindungsgemäß hergestellte Siliziumoxinitrid-Schicht zeigt,

Figur 5B ein Diagramm, das schematisch die Abhängigkeit unterschiedlicher physikalischer Parameter einer erfindungsgemäß hergestellten Siliziumnitrid-Schicht von der Ammoniak-Flussrate zeigt,

Figur 5C ein Diagramm, das schematisch die Abhängigkeit unterschiedlicher physikalischer Parameter einer erfindungsgemäß hergestellten Siliziumoxinitrid-Schicht von der Distickstoffmonoxid-Flussrate zeigt.

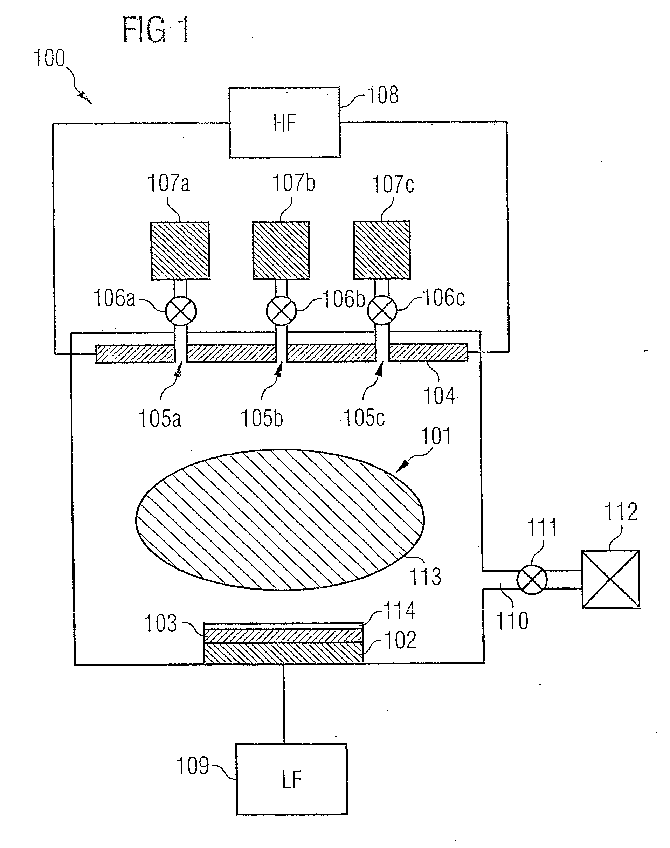

Im Weiteren wird anhand des in **Fig.1** gezeigten PECVD-Reaktors 100 ein bevorzugtes Ausführungsbeispiel des erfindungsgemäßen Plasmaangeregten chemischen Gasphasenabscheide-Verfahrens zum Abscheiden von Siliziumnitrid auf einem Substrat beschrieben.

Der in Fig.1 gezeigte PECVD-Reaktor 100 weist eine Verfahrenskammer 101 auf. In der Verfahrenskammer 101 ist auf einer Halte-Vorrichtung 102 ein Silizium-Wafer 103 montiert. Ferner ist in der Verfahrenskammer 101 eine in mehrere Abschnitte aufgeteilte Elektrode 104 angeordnet, welche drei Öffnungen 105a, 105b, 105c aufweist. Durch die erste Öffnung 105a kann, sofern ein erstes Ventil 106a geöffnet ist, Silan-Gas ($SiH_4$) aus dem ersten Reservoir 107a in die Verfahrenskammer 101 eingeleitet werden. Ferner kann in die Verfahrenskammer 101 durch die zweite Öffnung 105b, falls ein zweites Ventil 106b geöffnet ist, Ammoniakgas ($NH_3$) in die Verfahrenskammer eingeleitet werden. Darüber hinaus kann durch eine dritte Öffnung 105c, falls ein drittes Ventil 106c geöffnet ist, Stickstoffgas ($N_2$) aus dem dritten Reservoir 107c in die Verfahrenskammer 101 eingeleitet werden. Die Elektrode 104 ist mit einer HF-Spannungsquelle 108 zum Erzeugen eines hochfrequenten elektrischen Feldes in der Verfahrenskammer gekoppelt. Ferner ist gemäß dem gezeigten Ausführungsbeispiel die Halte-Vorrichtung 102 mit einer LF-Spannungsquelle 109 zum Erzeugen eines niederfrequenten Spannungssignals und zum Anlegen desselben an die Halte-Vorrichtung 102 und an den Wafer 103 gekoppelt. Ferner weist der PECVD-Reaktor 100 einen Gas-Auslass 110 auf, aus dem Gas, sofern das vierte Ventil 111 geöffnet ist, aus der Verfahrenskammer 101 entfernt werden können. Des Weiteren ist in Fig.1 eine Pumpe 112 gezeigt, mit der nicht benötigte Reaktionsprodukte durch den Gas-Auslass 110 aus der Verfahrenskammer 101 herausgepumpt werden und mit der in der Verfahrenskammer 101 ein gewünschter Druck eingestellt wird.

Beim Betrieb des PECVD-Reaktors 100 wird mittels der HF-Spannungsquelle 108 eine solche Hochfrequenz-Spannung an die Elektrode 104 angelegt, dass mittels der Elektrode 104 in der Verfahrenskammer 101 ein starkes elektrisches Wechselfeld entsteht. Aus dem ersten Reservoir 107a wird Silan mit einer geeigneten Flussrate, die beispielsweise mittels Justierens des ersten Ventils 106a eingestellt werden kann, in die Verfahrenskammer 101 eingelassen. Ferner wird aus dem zweiten Reservoir 107 Ammoniak-Gas einer geeigneten Flussrate in die Verfahrenskammer 101 eingeleitet, wobei die Flussrate beispielsweise mittels des zweiten Ventils 106b einstellbar ist. Aus dem dritten Reservoir 107c wird Stickstoff-Gas einer geeigneten Flussrate, welche mittels Justierens des dritten Ventils 106c eingestellt wird, in die Verfahrenskammer 101 eingelassen. Die eingelassenen Gasmoleküle werden mittels des hochfrequenten elektrischen Feldes in den Plasma-Zustand gebracht. Mit anderen Worten werden die Gasmoleküle in Radikale umgewandelt, beispielsweise werden aus Silan chemisch hochreaktive Silizium-Radikale erzeugt. Dadurch bildet sich ein Plasma 113. Simultan zu dem hochfrequenten elektrischen Feld, das mittels der HF-Spannungsquelle 108 erzeugt wird, wird mittels der LF-Spannungsquelle 109 eine niederfrequente elektrische Spannung über die Halte-Vorrichtung 102 an den Wafer 103 angelegt. Diese niederfrequente Spannung sorgt dafür, dass der Wafer 103 gegenüber dem positiv geladenem Plasma 113 negativ vorgespannt wird. Infolge elektrischer Kräfte diffundieren die Radikale des Plasmas 113 zu der Oberfläche des Silizium-Wafers 103 und werden dort adsorbiert. Auf der heißen Oberfläche des Silizium-Wafers 104 reagieren die Radikale chemisch und bilden so eine Silziumnitrid-Schicht 114 auf der Oberfläche des Wafers 103. Die Reaktionsgleichung dieser chemischen Reaktion auf der Oberfläche des Silizium-Wafers 103 weist die folgende Form auf:

$$SiH_4 + NH_3 + N_2 \rightarrow SiN_x + \qquad (2)$$

Gemäß diesem Ausführungsbeispiel werden Silan, Ammoniak und Stickstoff als Precursoren verwendet. Als Durchflussrate von Silan werden gemäß dem beschriebenen Ausführungsbeispiel 300 Standardkubikzentimeter pro Minute eingestellt, als Durchflussrate von Ammoniak werden 1000 Standardkubikzentimeter pro Minute eingestellt, als Durchflussrate von Stickstoff werden 1600 Standardkubikzentimeter pro Minute eingestellt, der Druck in der Verfahrenskammer wird auf ungefähr 350Pa eingestellt und die Hochfrequenz-Leistung der HF-Spannungsquelle 108 (HF="high frequency") sowie die Niederfrequenz-Leistung der LF-Spannungsquelle 109 (LF="low frequency") wird jeweils auf 500W eingestellt. Der Druck kann mittels Justierens des Ventils 111 und der Arbeitsparameter der Pumpe 112 eingestellt werden. Gemäß dem beschriebenen Ausführungsbeispiel wird also das Flussratenverhältnis von Silan zu Ammoniak auf ungefähr 3:10 eingestellt, wohingegen das Flussratenverhältnis zwischen Silan und Stickstoff auf ungefähr 3:16 eingestellt wird. Es ist zu betonen, dass die LF-Spannungsquelle 109 optional ist und lediglich die Funktion erfüllt, das positiv geladene Plasma in einem Umgebungsbereich der Oberfläche des Silizium-Wafers 103 zu akkumulieren, wodurch das Stattfinden einer chemischen Reaktion auf der Oberfläche des Silizium-Wafers 103 begünstigt wird. Die LF-Spannungsquelle 109 kann jedoch auch weggelassen werden. Gemäß dem beschriebenen Ausführungsbeispiel wird als Frequenz der HF-Spannungsquelle 13,56MHz gewählt, wohingegen als Frequenz für die LF-Spannungsquelle gemäß dem beschriebenen Ausführungsbeispiel 100kHz gewählt wird. Als PECVD-Reaktor 100 ist gemäß dem beschriebenen Ausführungsbeispiel das "Novellus Concept One" System der Firma Novellus™ gewählt.

Es ist zu betonen, dass anstatt des in Fig.1 gezeigten PECVD-Reaktors jeder andere geeignete PECVD-Reaktor verwendet werden kann, um das erfindungsgemäße Verfahren durchzuführen.

Der PECVD-Reaktor 100 kann auch dafür verwendet werden, das erfindungsgemäße Plasmaangeregte chemische Gasphasenabscheide-Verfahren zum Abscheiden von Siliziumoxinitrid auf einem Substrat durchzuführen. Dazu wird vor der Durchführung des erfindungsgemäßen Verfahrens in das erste Reservoir 107a Silan-Gas, in das zweite Reservoir 107b Distickstoffmonoxid ($N_2O$) und in das dritte Reservoir 107c Stickstoff ($N_2$) eingefüllt. Das Erzeugen einer Siliziumoxinitrid-Schicht auf der Oberfläche des Silizium-Wafers 103 erfolgt in diesem Fall gemäß der Reaktionsgleichung:

$$SiH_4 + N_2O + N_2 \rightarrow SiO_yN_z + \qquad (3)$$

Gemäß dem beschriebenen Ausführungsbeispiel wird die Durchflussrate von Silan auf 130sccm eingestellt, die Durchflussrate von Distickstoffmonoxid wird auf 120sccm eingestellt, die Durchflussrate von Stickstoff wird auf 8000sccm eingestellt, der Druck in der Verfahrenskammer 101 wird auf ungefähr 350Pa eingestellt, die Hochfrequenz-Leistung der HF-Spannungsquelle 108 wird auf ungefähr 300W eingestellt und die LF-Spannungsquelle 109 wird ausgeschaltet, d.h. nicht verwendet.

Eine Grundidee der Erfindung kann anschaulich darin gesehen werden, dass eine Siliziumnitrid-Schicht bzw. eine Siliziumoxinitrid-Schicht bereitgestellt wird, in welcher der Anteil von Silizium mittels Verwendens des PECVD-Verfahrens und mittels einer geschickten Prozessführung erhöht wird, wodurch infolge der hohen relativen Dielektrizitätskonstante von Silizium die relative Dielektrizitätskonstante der entstehenden Siliziumnitrid- bzw. Siliziumoxinitrid-Schicht erhöht ist. Mittels Variation der Prozessgase (Silan, Stickstoff sowie Ammoniak oder Distickstoffmonoxid) ist ein stöchiometrisch exaktes Justieren des Silizium-Anteils der entstehenden Siliziumnitrid- oder Siliziumoxinitrid-Schichten ermöglicht.

Eine Grundidee der Erfindung kann auch darin gesehen werden, dass bei der Herstellung einer Siliziumnitrid-Schicht unter Verwendung des PECVD-Verfahrens erfindungsgemäß die Flussrate von Ammoniak reduziert wird bzw. dass zum Herstellen einer Siliziumoxinitrid-Schicht die Flussrate von Distickstoffmonoxid reduziert wird, sodass eine gewünschte, vorgebbare Stöchiometrie mit einem erhöhten hohen Anteil Silizium in den resultierenden Siliziumnitrid- bzw. Siliziumoxinitrid-Schichten erhalten wird.

Im Weiteren werden experimentelle Untersuchungen der erfindungsgemäß hergestellten Siliziumnitrid- bzw. Siliziumoxinitrid-Schichten erläutert und so die vorteilhaften Eigenschaften des erfindungsgemäßen Verfahrens aufgezeigt. Ferner werden die physikalisch-chemischen Zusammenhänge zwischen Wahl der Prozessparameter des PECVD-Verfahrens und der entstehenden Schichten erläutert.

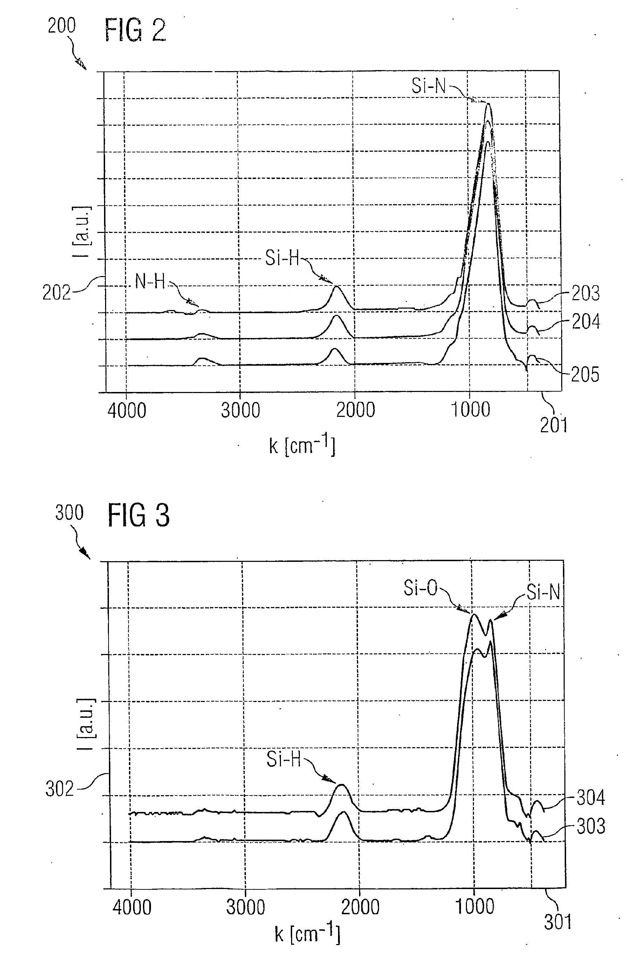

In **Fig.2** ist ein Diagramm 200 gezeigt, das ein FTIR-Spektrum ("Fourier transform infrared spectroscopy") erfindungsgemäß hergestellter Siliziumnitrid-Schichten zeigt.

Entlang der Abszisse 201 ist die Wellenzahl k (in $cm^{-1}$) der auf die erfindungsgemäß hergestellte Siliziumnitrid-Schicht eingestrahlten Infrarotstrahlung gezeigt. Entlang der Ordinate 202 des Diagramms 200 ist die Intensität der absorbierten Infrarotstrahlung (in beliebigen Einheiten) aufgetragen. Jedem Peak in einem FTIR-Spektrum ist ein charakteristisches Material bzw. eine charakteristische chemische Bindung zugeordnet. In dem Diagramm 200 weisen die drei gezeigten Kurven 203, 204, 205 Peaks auf, die charakteristisch für N-H Bindungen, Si-H Bindungen bzw. Si-N Bindungen sind. Daher ist die Intensität der entsprechenden Peaks ein Maß für den stöchiometrischen Anteil des entsprechenden Elements bzw. der entsprechenden chemischen Bindung in der untersuchten Siliziumnitrid-Schicht.

Eine erste Kurve 203 zeigt ein FTIR-Spektrum, wie es bei Durchführung des erfindungsgemäßen Plasmaangeregten chemischen Gasphasenabschalteverfahrens zum Abscheiden von Siliziumnitrid unter Verwendung einer Ammoniak-Durchflussrate von 1500 Standardkubikzentimetern pro Minute erhalten wird. Eine zweite Kurve 204 korrespondiert mit einer Ammoniak-Flussrate von 2000 Standardkubikzentimetern pro Minute und eine dritte Kurve 205 zeigt das FTIR-Spektrum bei einer Ammoniak-Flussrate von 4000 Standardkubikzentimetern pro Minute. An dem in dem Diagramm 200 mit der Beschriftung "Si-H" gekennzeichneten Peak ist zu erkennen, dass der Anteil von Silizium-Wasserstoff-Bindungen in der erhaltenen Siliziumnitrid-Schicht umso höher ist, je geringer die Ammoniak-Flussrate gewählt ist. Mit anderen Worten führt eine Verringerung der Ammoniak-Flussrate zu einer Erhöhung des Silizium-Anteils in der resultierenden Siliziumnitrid-Schicht. Daher kann mittels Reduzierens der Ammoniak-Flussrate bei Durchführung des PECVD-Verfahrens der Silizium-Anteil in der resultierenden Siliziumnitrid-Schicht erhöht werden und dadurch die relative Dielektrizitätskonstante der entstehenden Schicht erhöht werden.

In **Fig.3** ist ein Diagramm 300 gezeigt, in dem das FTIR-Spektrum erfindungsgemäß hergestellter Siliziumoxinitrid-Schichten gezeigt ist. Wiederum ist entlang der Abszisse 301 die Wellenzahl k (in $cm^{-1}$) der eingestrahlten Infrarotstrahlung gezeigt. Entlang der Ordinate 302 ist die Infrarotabsorption I (in beliebigen Einheiten) aufgetragen. Das Diagramm 300 zeigt eine erste Kurve 303 und eine zweite Kurve 304. Die erste Kurve 303 zeigt das erhaltene FTIR-Spektrum einer erfindungsgemäß hergestellten Siliziumoxinitrid-Schicht für den Fall, dass der Distickstoffmonoxid-Durchfluss auf 160 Standardkubikzentimeter pro Minute eingestellt wird. Dagegen ist im Falle der zweiten Kurve 304 die Flussrate von Distickstoffmonoxid auf 200 Standardkubikzentimeter pro Minute eingestellt. Wie anhand der beiden teilweise überlappenden Resonanzen von Si-O bzw. Si-N in der Region von ungefähr $1000 cm^{-1}$ zu erkennen ist, führt eine Verringerung der Distickstoffmonoxid-Flussrate zu einer relativen Verschiebung der Gewichtung Si-O/Si-N hin zu der Si-N Komponente. Mit anderen Worten nimmt der Anteil von stickstoffligandiertem Silizium zu, wenn die Distickstoffmonoxid-Flussrate reduziert wird. Stöchiometrisches Siliziumoxid tritt in der Konfiguration $SiO_2$ auf, sodass das Siliziumdioxid zu einem Drittel Silizium aufweist. Dagegen ist die stöchiometrische Zusammensetzung von Siliziumnitrid üblicherweise $Si_3N_4$, sodass die Siliziumnitrid-Komponente 3/7 Silizium aufweist. Eine Zunahme der stickstoffligandierten Silizium-Komponente im FTIR-Spektrum bei einer gleichzeitigen Abnahme der sauerstoffligandierten Silizium-Komponente führt daher zu einer Erhöhung des Silizium-Anteils in der Siliziumoxinitrid-Schicht, sodass Silizium-reichere Schichten erhalten werden, wenn die Flussrate von Distickstoffmonoxid reduziert wird. Daher kann mittels Reduzierens der Flussrate von Distickstoffmonoxid (d.h. mittels erfindungsgemäßer Wahl der Flussratenverhältnisse) die relative Dielektrizitätskonstante ε der resultierenden Siliziumoxinitrid-Schicht erhöht werden.

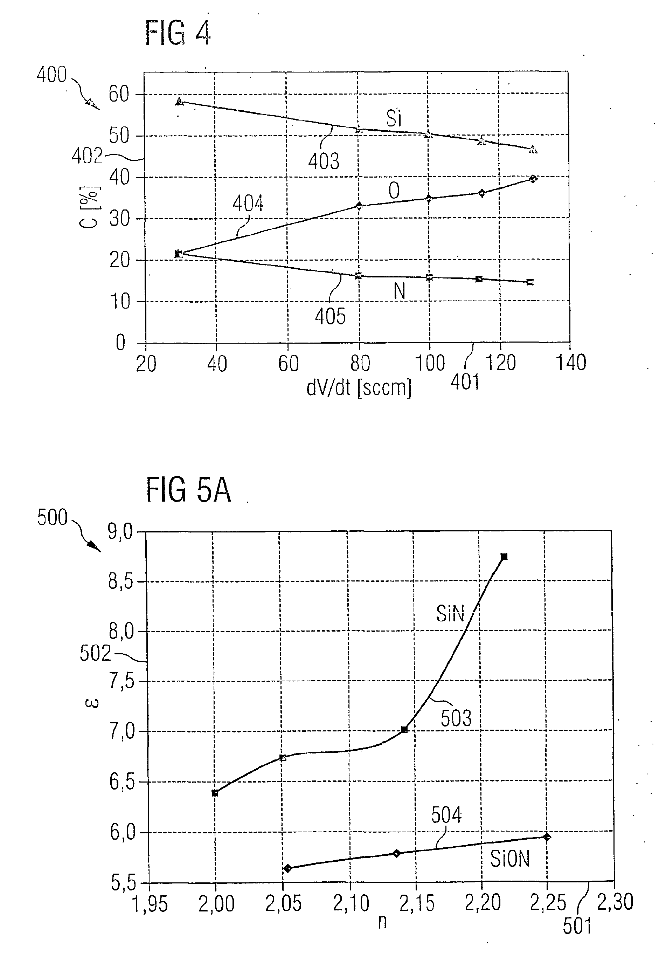

In **Fig.4** ist ein Diagramm 400 gezeigt, das auf RBS-Untersuchungen ("Rayleigh Backscattering Spectroscopy") erfindungsgemäß hergestellter Siliziumoxinitrid-Schichten beruht. Bei der RBS Methode wird die Zusammensetzung einer Schicht ermittelt, indem energiereiche Ionen an einem Festkörper aufgrund des elektrostatischen Potentials der Atomkerne gestreut werden. Aus dem Streuspektrum kann die quantitative Zusammensetzung einer untersuchten Schicht ermittelt werden.

Bei dem in Fig.4 gezeigten Diagramm 400 sind entlang der Abszisse 401 unterschiedliche Distickstoffmonoxid-Flussraten in sccm (Standardkubikzentimeter pro Minute) beim Herstellen erfindungsgemäßer Siliziumoxinitrid-Schichten aufgetragen. Entlang der Ordinate 402 sind die aus dem RBS-Spektrum ermittelten Anteile der Elemente Silizium (Si), Sauerstoff (O) bzw. Stickstoff (N) aufgetragen. Es wurden unterschiedliche Distickstoffmonoxid-Flussraten, aber eine konstante Silan-Flussrate verwendet, um die zugehörigen Siliziumoxinitrid-Schichten herzustellen. Eine erste Kurve 403 zeigt die Abhängigkeit des Silizium-Beitrags in der Siliziumoxinitrid-Schicht für die unterschiedlichen Distickstoffmonoxid-Flussraten. Eine zweite Kurve 404 zeigt die Abhängigkeit des Sauerstoff-Beitrags in den hergestellten Siliziumoxinitrid-Schichten. Eine dritte Kurve 405 zeigt den Beitrag der Stickstoff-Komponente in den Siliziumoxinitrid-Schichten. Wie aus Fig.4 hervorgeht, besteht eine Korrelation zwischen dem Silizium-Beitrag in einer derartig hergestellten Siliziumoxinitrid-Schicht und der für das PECVD-Verfahren verwendeten Distickstoffmonoxid-Flussrate. Je geringer die Distickstoffmonoxid-Flussrate gewählt ist, desto höher ist der relative Anteil des Siliziums. Daher kann die relative Dielektrizitätskonstante der resultierenden Siliziumoxinitrid-Schicht dadurch erhöht werden, dass die Distickstoffmonoxid-Flussrate verringert wird.

In **Fig.5A** ist ein Diagramm 500 gezeigt, das die Abhängigkeit der relativen Dielektrizitätskonstante ε (dimensionslos) einer erfindungsgemäß hergestellten Siliziumnitrid- bzw. Siliziumoxinitrid-Schicht von dem Brechungsindex n (dimensionslos) der Schicht für Licht einer Wellenlänge von 635nm zeigt. Entlang der Abszisse 501 ist der Brechungsindex n aufgetragen. Entlang der Ordinate 502 sind Werte der relativen Dielektrizitätskonstante ε der Siliziumnitrid- bzw. Siliziumoxinitrid-Schichten aufgetragen.

Wie aus Fig.5A hervorgeht, sind die Abhängigkeiten für Siliziumnitrid (erste Kurve 503) bzw. für Siliziumoxinitrid (zweite Kurve 504) jeweils monoton steigend. Mit anderen Worten führt eine Erhöhung des Brechungsindex n zu einer Erhöhung der relativen Dielektrizitätskonstante ε.

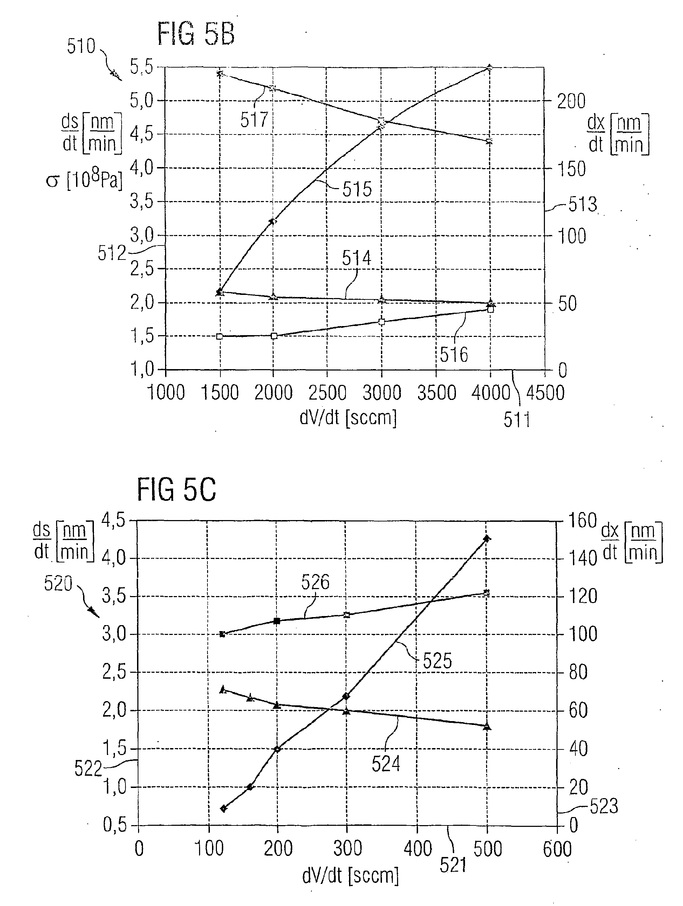

Bezugnehmend auf das in **Fig.5B** gezeigte Diagramm 510 wird im Weiteren die Abhängigkeit einer Reihe physikalischer Parameter einer hergestellten Siliziumnitrid-Schicht von der Ammoniak-Flussrate dV/dt (in sccm) während des erfindungsgemäßen PECVD-Verfahrens erläutert. Entlang der Abszisse 511 sind unterschiedliche Flussraten von Ammoniak in Standardkubikzentimetern pro Minute aufgetragen. Entlang einer ersten Ordinate 512 ist der Brechungsindex n (dimensionslos), die Nassätzrate ds/dt (in nm pro Minute) und die Druckspannung σ der Siliziumnitrid-Schicht (in $10^8$ Pa) aufgetragen. Entlang einer zweiten Ordinate 513 des Diagramms 510 ist die Abscheiderate dx/dt (in nm pro Minute) aufgetragen.

Eine erste Kurve 514 zeigt die Abhängigkeit des Brechungsindex n der erfindungsgemäß hergestellten Siliziumnitrid-Schicht von der eingestellten Ammoniak-Flussrate. Wie in Fig.5B gezeigt, besteht eine eindeutige Korrelation zwischen einer Verringerung der Ammoniak-Flussrate dV/dt und einer Erhöhung des Brechungsindex n. Bezugnehmend auf Fig.5A korrespondiert ein erhöhter Brechungsindex einer Siliziumnitrid-Schicht (vgl. erste Kurve 503) mit einer Erhöhung der relativen Dielektrizitätskonstante der Schicht. Fasst man die Aussagen des Diagramms 510 und des Diagramms 500 zusammen, so führt eine Verringerung der Ammoniak-Flussrate zu einer Erhöhung der relativen Dielektrizitätskonstante. Dies ist ein wesentlicher Effekt, welcher der Erfindung zugrunde liegt.

Ferner ist in Fig.5B eine zweite Kurve 515 gezeigt, welche die Abhängigkeit der Nassätzrate ds/dt (in nm pro Minute) von der Ammoniak-Flussrate dV/dt zeigt. Eine verringerte Ammoniak-Flussrate führt daher nicht nur zu einer Erhöhung der relativen Dielektrizitätskonstante, sondern auch zu einer deutlichen Verringerung der Nassätzrate. Eine ausreichend geringe Nassätzrate gewährleistet, dass ein definiertes Zurückätzen einer erfindungsgemäß hergestellten Schicht ermöglicht ist. Da bei erhöhter Dielektrizitätskonstante die Nassätzrate der erfindungsgemäß hergestellten Siliziumnitrid-Schicht verringert ist, ist das Weiterprozessieren einer solchen Schicht unter definierten Bedingungen ermöglicht.

Darüber hinaus ist in dem Diagramm 510 eine dritte Kurve 516 gezeigt, welche die Abhängigkeit der Druckspannung σ (in $10^8$Pa) von der Ammoniak-Flussrate zeigt. Eine Erhöhung der relativen Dielektrizitätskonstante infolge der Verringerung der Ammoniak-Flussrate geht daher mit einer Verringerung der Druckspannung und folglich einer verringerten Eigenspannung der Siliziumnitrid-Schicht einher, was vorteilhaft ist.

Ferner ist in dem Diagramm 510 eine vierte Kurve 517 gezeigt, welche die Abhängigkeit der Siliziumnitrid-Abscheiderate von der Ammoniak-Flussrate zeigt. Je geringer die Ammoniak-Flussrate gewählt wird, desto höher ist die Abscheiderate.

Im Weiteren wird bezugnehmend auf **Fig.5C** das dort gezeigte Diagramm 520 erläutert, das für erfindungsgemäß hergestellte Siliziumoxinitrid-Schichten die Abhängigkeit unterschiedlicher physikalischer Parameter von der Distickstoffmonoxid-Flussrate (in sccm) zeigt.

Entlang der Abszisse 511 ist die Flussrate von Distickstoffmonoxid bei dem erfindungsgemäßen PECVD-Verfahren aufgetragen. Ferner ist entlang einer ersten Ordinate 522 der Brechungsindex n aufgetragen (dimensionslos), und es ist die Nassätzrate ds/dt (in nm pro Minute) aufgetragen. Entlang einer zweiten Ordinate 523 ist die Abscheiderate von Siliziumoxinitrid, wie sie gemäß dem erfindungsgemäßen Verfahren erhalten wird, aufgetragen.

Eine erste Kurve 524 in dem Diagramm 520 zeigt die Abhängigkeit des Brechungsindex n von der Distickstoffmonoxid-Flussrate. Aus der ersten Kurve 524 aus Fig.5C und aus der zweiten Kurve 504 aus Fig.5A ist die Korrelation ersichtlich, dass eine Verringerung der Distickstoffmonoxid-Flussrate zu einer Erhöhung der relativen Dielektrizitätskonstante ε führt.

Eine Kurve 525 aus Fig.5C zeigt die Abhängigkeit der Nassätzrate ds/dt von der Flussrate von Distickstoffmonoxid während des PECVD-Verfahrens. Auch im Falle von Siliziumoxinitrid führt eine Verringerung der Flussrate (in diesem Falle von Distickstoffmonoxid) zu einer Verringerung der Nassätzrate, sodass mit einer Verringerung der Distickstoffmonoxid-Flussrate eine Weiterprozessierung der erfindungsgemäß hergestellten Siliziumoxinitrid-Schicht unter definierten Verfahrensbedingungen ermöglicht ist.

Ferner ist in dem Diagramm 520 eine dritte Kurve 526 gezeigt, welche die Abhängigkeit der Siliziumoxinitrid-Abscheiderate von der Distickstoffmonoxid-Flussrate zeigt. Anders als im Falle der Siliziumnitrid-Schicht (vgl. Kurve 517 aus Diagramm 510) führt im Falle von Siliziumoxinitrid eine Verringerung der Flussrate (in diesem Fall von Distickstoffmonoxid) zu einer Verringerung der Abscheiderate 526.

Die beschriebenen physikalischen Parameter der erfindungsgemäß hergestellten Siliziumnitrid- bzw. Siliziumoxinitrid-Schichten sowie die Abhängigkeit der physikalischen Parameter dieser Schichten von den Prozessbedingungen zeigt, dass mittels einer Verringerung der Flussraten von Ammoniak bzw. von Distickstoffmonoxid während eines PECVD-Verfahrens Schichten mit einem erhöhten $\varepsilon$ und vorteilhaften Materialeigenschaften erhalten werden.

Insbesondere weisen solche Schichten die erforderlichen elektrischen, mechanischen und optischen Eigenschaften auf, um als dielektrische Schichten eines MIM-Kondensators geeignet zu sein.

In diesem Dokument sind folgende Veröffentlichungen zitiert:

[1] US 6,383,874 B1

[2] US 4,618,541

[3] US 6,316,820 B1

[4] US 6,372,668 B2

[5] US 6,309,932 B1

[6] US 5,466,617

[7] US 5,164,339

[8] US 6,383,874 B1

[9] US 6,324,439 B1

[10] EP 0, 454, 100 A2

[11] Odekirk et al. Proceedings of the Symposium on Dielectric Films on Compound Semiconductors, Las Vegas, NV, USA, 14 - 17 Oktober 1985, Seiten 274 - 286

[12] US 6,221,794 B1

Bezugszeichenliste

| | |
|---|---|
| 100 | PECVD-Reaktor |
| 101 | Verfahrenskammer |
| 102 | Halte-Vorrichtung |
| 103 | Silizium-Wafer |
| 104 | Elektrode |
| 105a | erste Öffnung |
| 105b | zweite Öffnung |
| 105c | dritte Öffnung |
| 106a | erstes Ventil |
| 106b | zweites Ventil |
| 106c | drittes Ventil |
| 107a | erstes Reservoir |
| 107b | zweites Reservoir |
| 107c | drittes Reservoir |
| 108 | HF-Spannungsquelle |
| 109 | LF-Spannungsquelle |
| 110 | Gas-Auslass |
| 111 | viertes Ventil |
| 112 | Pumpe |
| 113 | Plasma |

| | |
|---|---|
| 114 | Siliziumnitrid-Schicht |
| 200 | Diagramm |
| 201 | Abszisse |
| 202 | Ordinate |
| 203 | erste Kurve |
| 204 | zweite Kurve |
| 205 | dritte Kurve |
| 300 | Diagramm |
| 301 | Abszisse |
| 302 | Ordinate |
| 303 | erste Kurve |
| 304 | zweite Kurve |
| 400 | Diagramm |
| 401 | Abszisse |
| 402 | Ordinate |
| 403 | erste Kurve |
| 404 | zweite Kurve |
| 405 | dritte Kurve |
| 500 | Diagramm |
| 501 | Abszisse |
| 502 | Ordinate |
| 503 | erste Kurve |
| 504 | zweite Kurve |
| 510 | Diagramm |
| 511 | Abszisse |
| 512 | erste Ordinate |
| 513 | zweite Ordinate |
| 514 | erste Kurve |
| 515 | zweite Kurve |
| 516 | dritte Kurve |
| 517 | vierte Kurve |
| 520 | Diagramm |
| 521 | Abszisse |
| 522 | erste Ordinate |
| 523 | zweite Ordinate |
| 524 | erste Kurve |
| 525 | zweite Kurve |
| 526 | dritte Kurve |

**Patentansprüche**

1. Verfahren zum Herstellen eines MIM-Kondensators, bei dem

 • eine erste elektrisch leitfähige Metall-Schicht auf einem Substrat ausgebildet wird;
 • eine Siliziumnitrid-Schicht auf der ersten elektrisch leitfähigen Metall-Schicht ausgebildet wird;
 • eine zweite elektrisch leitfähige Metall-Schicht auf der Siliziumnitrid-Schicht ausgebildet wird;

 wobei die Siliziumnitrid-Schicht unter Verwendung eines plasmaangeregten chemischen Gasphasenabscheide-Verfahrens ausgebildet wird, bei dem

 • Silan, Ammoniak und Stickstoff als Precursoren verwendet werden;
 • das Flussratenverhältnis von Silan zu Ammoniak zwischen 1:20 und 6:5 eingestellt wird;
 • das Flussratenverhältnis zwischen Silan und Stickstoff zwischen 1:40 und 3:5 eingestellt wird;
 • der Druck in der Verfahrenskammer zwischen 260Pa und 530Pa eingestellt wird.

2. Verfahren nach Anspruch 1,
 bei dem ein Hochfrequenz-Feld mit einer Leistung zwischen 300W und 700W zum Erzeugen des Plasmas angelegt wird.

**3.** Verfahren nach Anspruch 1 oder 2,
bei dem ein Niederfrequenz-Feld mit einer Leistung zwischen 300W und 700W zum Akkumulieren von Plasma in einem Umgebungsbereich des Substrats angelegt wird.

**4.** Verfahren nach einem der Ansprüche 1 bis 3,
bei dem die Flussrate von Silan auf einen Wert zwischen 100 und 600 Standardkubikzentimeter pro Minute eingestellt wird.

**5.** Verfahren nach Anspruch 3 oder 4,
bei dem

  • das Flussratenverhältnis von Silan zu Ammoniak zwischen 1:10 und 3:5 eingestellt wird; und
  • das Flussratenverhältnis zwischen Silan und Stickstoff zwischen 1:20 und 3:10 eingestellt wird;
  • der Druck in der Verfahrenskammer zwischen 360Pa und 430Pa eingestellt wird;
  • die Leistung des Hochfrequenz-Feldes und die Leistung des Niederfrequenz-Feldes voneinander unabhängig jeweils auf einen Wert zwischen 400W und 600W eingestellt werden.

**6.** Verfahren nach einem der Ansprüche 3 bis 5,
bei dem

  • das Flussratenverhältnis von Silan zu Ammoniak auf ungefähr 3:10 eingestellt wird;
  • das Flussratenverhältnis zwischen Silan und Stickstoff auf ungefähr 3:16 eingestellt wird;
  • der Druck in der Verfahrenskammer auf ungefähr 350Pa eingestellt wird;
  • die Hochfrequenz-Leistung und die Niederfrequenz-Leistung jeweils auf ungefähr 500W eingestellt werden.

**7.** Verfahren nach Anspruch 6,
bei dem die Flussrate von Silan auf ungefähr 300 Standardkubikzentimeter pro Minute eingestellt wird.

**8.** Verfahren zum Herstellen eines MIM-Kondensators,
bei dem

  • eine erste elektrisch leitfähige Metall-Schicht auf einem Substrat ausgebildet wird;
  • eine Siliziumoxinitrid-Schicht auf der ersten elektrisch leitfähigen Metall-Schicht ausgebildet wird;
  • eine zweite elektrisch leitfähige Metall-Schicht auf der Siliziumoxinitrid-Schicht ausgebildet wird;

wobei die Siliziumoxinitrid-Schicht unter Verwendung eines plasmaangeregten chemischen Gasphasenabscheide-Verfahrens ausgebildet wird, bei dem

  • Silan, Distickstoffmonoxid und Stickstoff als Precursoren verwendet werden;
  • das Flussratenverhältnis von Silan zu Distickstoffmonoxid zwischen 1:2 und 25:4 eingestellt wird;
  • das Flussratenverhältnis zwischen Silan und Stickstoff zwischen 1:100 und 1:10 eingestellt wird.

**9.** Verfahren nach Anspruch 8,
bei dem der Druck in der Verfahrenskammer zwischen 260Pa und 530Pa eingestellt wird.

**10.** Verfahren nach Anspruch 8 oder 9,
bei dem ein Hochfrequenz-Feld mit einer Leistung zwischen 200W und 500W zum Erzeugen des Plasmas angelegt wird.

**11.** Verfahren nach einem der Ansprüche 8 bis 10,
bei dem ein Niederfrequenz-Feld mit einer Leistung von bis zu 300W zum Akkumulieren von Plasma in einem Umgebungsbereich des Substrats angelegt wird.

**12.** Verfahren nach einem der Ansprüche 8 bis 11,
bei dem die Flussrate von Silan auf einen Wert zwischen 100 und 500 Standardkubikzentimeter pro Minute eingestellt wird.

**13.** Verfahren nach Anspruch 11 oder 12,
bei dem

- das Flussratenverhältnis von Silan zu Distickstoffmonoxid zwischen 1:1 und 25:8 eingestellt wird;
- das Flussratenverhältnis zwischen Silan und Stickstoff zwischen 1:50 und 1:20 eingestellt wird;
- der Druck in der Verfahrenskammer zwischen 350Pa und 430Pa eingestellt wird;
- die Leistung des Hochfrequenz-Feldes auf einen Wert zwischen 300W und 400W und die Leistung des Niederfrequenz-Feldes auf einen Wert von bis zu 150W eingestellt werden.

**14.** Verfahren nach einem der Ansprüche 11 bis 13,
bei dem

- das Flussratenverhältnis von Silan zu Distickstoffmonoxid auf ungefähr 13:12 eingestellt wird;
- das Flussratenverhältnis zwischen Silan und Stickstoff auf ungefähr 13:800 eingestellt wird;
- der Druck in der Verfahrenskammer auf ungefähr 350Pa eingestellt wird;
- die Leistung des Hochfrequenz-Feldes auf ungefähr 300W eingestellt wird.

**15.** Verfahren nach Anspruch 14,
bei dem die Flussrate von Silan auf ungefähr 130 Standardkubikzentimeter pro Minute eingestellt wird.

**16.** Verfahren nach einem der Ansprüche 1 bis 15,
bei dem als Substrat ein Halbleiter-Substrat verwendet wird.

**17.** Verfahren nach einem der Ansprüche 1 bis 16,
bei dem als Substrat ein Silizium-Substrat verwendet wird.

**Claims**

**1.** A method for producing a MIM capacitor,
in which

- a first electrically conductive metal layer is formed on a substrate;
- a silicon nitride layer is formed on the first electrically conductive metal layer;
- a second electrically conductive metal layer is formed on the silicon nitride layer;

wherein the silicon nitride layer is formed using a plasma-enhanced chemical vapor deposition process, in which

- silane, ammonia and nitrogen are used as precursors;
- the silane-to-ammonia flow rate ratio is set between 1:20 and 6:5;
- the silane-to-nitrogen flow rate ratio is set between 1:40 and 3:5;
- the pressure in the process chamber is set between 260 Pa and 530 Pa.

**2.** The method according to claim 1,
in which a high-frequency field with a power of between 300 W and 700 W is applied to generate the plasma.

**3.** The method according to claim 1 or 2,
in which a low-frequency field with a power of between 300 W and 700 W is applied to accumulate plasma in an area surrounding the substrate.

**4.** The method according to one of claims 1 to 3,
in which the flow rate of silane is set to a value between 100 and 600 standard cubic centimetres per minute.

**5.** The method according to claim 3 or 4,
in which

- the silane-to-ammonia flow rate ratio is set between 1:10 and 3:5; and
- the silane-to-nitrogen flow rate ratio is set between 1:20 and 3:10;

• the pressure in the process chamber is set between 360 Pa and 430 Pa;
• the power of the high-frequency field and the power of the low-frequency field are each, independently of one another, set to a value between 400 W and 600 W.

6. The method according to one of claims 3 to 5,
in which

• the silane-to-ammonia flow rate ratio is set to approximately 3:10;
• the silane-to-nitrogen flow rate ratio is set to approximately 3:16;
• the pressure in the process chamber is set to approximately 350 Pa;
• the high-frequency power and the low-frequency power are each set to approximately 500 W.

7. The method according to claim 6,
in which the flow rate of silane is set to approximately 300 standard cubic centimetres per minute.

8. A method for producing a MIM capacitor,
in which

• a first electrically conductive metal layer is formed on a substrate;
• a silicon oxynitride layer is formed on the first electrically conductive metal layer;
• a second electrically conductive metal layer is formed on the silicon oxynitride layer;

wherein the silicon oxynitride layer is formed using a plasma-enhanced chemical vapor deposition process, in which

• silane, dinitrogen monoxide and nitrogen are used as precursors;
• the silane-to-dinitrogen monoxide flow rate ratio is set between 1:2 and 25:4;
• the silane-to-nitrogen flow rate ratio is set between 1:100 and 1:10.

9. The method according to claim 8,
in which the pressure in the process chamber is set between 260 Pa and 530 Pa.

10. The method according to claim 8 or 9,
in which a high-frequency field with a power of between 200 W and 500 W is applied to generate the plasma.

11. The method according to one of claims 8 to 10,
in which a low-frequency field with a power of up to 300 W is applied to accumulate plasma in an area surrounding the substrate.

12. The method according to one of claims 8 to 11,
in which the flow rate of silane is set to a value between 100 and 500 standard cubic centimetres per minute.

13. The method according to claim 11 or 12,
in which

• the silane-to-dinitrogen monoxide flow rate ratio is set between 1:1 and 25:8;
• the silane-to-nitrogen flow rate ratio is set between 1:50 and 1:20;
• the pressure in the process chamber is set between 350 Pa and 430 Pa;
• the power of the high-frequency field is set to a value between 300 W and 400 W and the power of the low-frequency field is set to a value of up to 150 W.

14. The method according to one of claims 11 to 13,
in which

• the silane-to-dinitrogen monoxide flow rate ratio is set to approximately 13:12;
• the silane-to-nitrogen flow rate ratio is set to approximately 13:800;
• the pressure in the process chamber is set to approximately 350 Pa;
• the power of the high-frequency field is set to approximately 300 W.

**15.** The method according to claim 14,
in which the flow rate of silane is set to approximately 130 standard cubic centimetres per minute.

**16.** The method according to one of claims 1 to 15,
in which a semiconductor substrate is used as the substrate.

**17.** The method according to one of claims 1 to 16,
in which a silicon substrate is used as the substrate.

**Revendications**

**1.** Procédé de production d'un condensateur MIM,
dans lequel

• on forme une première couche de métal conducteur de l'électricité sur un substrat ;
• on forme une couche de nitrure de silicium sur la première couche de métal conducteur de l'électricité ;
• on forme une deuxième couche de métal conducteur de l'électricité sur une couche de nitrure de silicium ;

dans lequel on forme la couche de nitrure de silicium en utilisant un procédé de dépôt chimique en phase gazeuse assisté par plasma, dans lequel

• on utilise un silane, de l'ammoniac et de l'azote comme précurseurs ;
• on règle le rapport de débit du silane à l'ammoniac entre 1:20 et 6:5 ;
• on règle le rapport de débit entre le silane et l'azote entre 1:40 et 3:5 ;
• on règle la pression dans la chambre du procédé entre 260 Pa et 530 Pa.

**2.** Procédé suivant la revendication 1
dans lequel on applique un champ de haute fréquence d'une puissance comprise entre 300 W et 700 W pour produire le plasma.

**3.** Procédé suivant la revendication 1 ou 2,
dans lequel on applique un champ de basse fréquence d'une puissance comprise entre 300 W et 700 W pour l'accumulation de plasma dans une zone ambiante du substrat.

**4.** Procédé suivant l'une des revendications 1 à 3,
dans lequel on règle le débit de silane à une valeur comprise entre 100 et 600 centimètres cube à la minute dans les conditions normales.

**5.** Procédé suivant la revendication 3 ou 4,
dans lequel

• on règle le rapport de débit du silane à l'ammoniac entre 1:10 et 3:5 ; et
• on règle le rapport de débit entre le silane et l'azote entre 1:20 et 3:10 ;
• on règle la pression dans la chambre de procédé entre 360 Pa et 430 Pa ;
• on règle la puissance de champ de haute fréquence et la puissance de champ de basse fréquence indépendamment l'un de l'autre, respectivement à une valeur comprise entre 400 W et 600 W.

**6.** Procédé suivant l'une des revendications 3 à 5,
dans lequel

• on règle le rapport de débit du silane à l'ammoniac à environ 3:10 ;
• on règle le rapport de débit entre le silane et l'azote à environ 3:16 ;
• on règle la pression dans la chambre de procédé à environ 350 Pa ;
• on règle la puissance de haute fréquence et la puissance de basse fréquence, respectivement à environ 500 W.

**7.** Procédé suivant la revendication 6,
dans lequel on règle le débit du silane à environ 350 centimètres cube à la minute dans les conditions normales.

**8.** Procédé de production d'un condensateur MIM,
dans lequel

   • on forme une première couche de métal conducteur de l'électricité sur un substrat ;
   • on forme une couche de nitrure de silicium sur la première couche de métal conducteur de l'électricité ;
   • on forme une deuxième couche de métal conducteur de l'électricité sur une couche de nitrure de silicium ;

dans lequel on forme la couche de nitrure de silicium en utilisant un procédé de dépôt chimique en phase gazeuse assisté par plasma, dans lequel

   • on utilise un silane, du monoxyde de diazote et de l'azote comme précurseurs,
   • on règle le rapport de débit du silane au monoxyde de diazote entre 1:2 et 25:4 ;
   • on règle le rapport de débit entre le silane et l'azote entre 1:100 et 1:10 ;

**9.** Procédé suivant la revendication 8,
dans lequel on règle la pression dans la chambre du procédé entre 260 Pa et 530 Pa.

**10.** Procédé suivant la revendication 8 ou 9,
dans lequel on applique un champ de haute fréquence d'une puissance comprise entre 200 W et 500 W pour produire le plasma.

**11.** Procédé suivant l'une des revendications 8 à 10,
dans lequel on applique un champ de basse fréquence d'une puissance allant jusqu'à 300 W pour accumuler du plasma dans une zone ambiante du substrat.

**12.** Procédé suivant l'une des revendications 8 à 11,
dans lequel on règle le débit de silane à une valeur comprise entre 100 et 500 centimètres cube à la minute dans les conditions normales.

**13.** Procédé suivant la revendication 11 ou 12,
dans lequel

   • on règle le rapport des débits du silane au monoxyde de diazote entre 1:1 et 25:8 ;
   • on règle le rapport des débits entre le silane et l'azote entre 1:50 et 1:20 ;
   • on règle la pression dans la chambre de procédé entre 350 Pa et 430 Pa ;
   • on règle la puissance du champ de haute fréquence à une valeur comprise entre 300 W et 400 W et la puissance du champ de basse fréquence à une valeur allant jusqu'à 150 W.

**14.** Procédé suivant l'une des revendications 11 à 13,
dans lequel

   • on règle le rapport des débits du silane au monoxyde de diazote à environ 13:12 ;
   • on règle le rapport des débits entre le silane et l'azote à environ 13:800 ;
   • on règle le pression dans la chambre de procédé à environ 350 Pa ;
   • on règle la puissance du champ de haute fréquence à environ 300 W.

**15.** Procédé suivant la revendication 14,
dans lequel on règle le débit de silane à environ 130 centimètres cube à la minute dans les conditions normales.

**16.** Procédé suivant l'une des revendications 1 à 15,
dans lequel on utilise comme substrat un substrat semiconducteur.

**17.** Procédé suivant l'une des revendications 1 à 16,
dans lequel on utilise comme substrat un substrat en silicium.

FIG 1

FIG 2

FIG 3

## FIG 4

400

C [%]

402

60 — Si
50 — 403
40 — O
30 — 404
20 —
10 — N
0 — 405

20   40   60   80   100   120   140
dV/dt [sccm]   401

## FIG 5A

500

ε

502

9,0 —
8,5 —
8,0 — SiN
7,5 —
7,0 — 503
6,5 —
6,0 — 504
5,5 — SiON

1,95   2,00   2,05   2,10   2,15   2,20   2,25   2,30
n   501

## FIG 5B

## FIG 5C

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6383874 B1
- US 4618541 A
- US 6316820 B1
- US 6372668 B2
- US 6309932 B1
- US 5466617 A
- US 5164339 A
- US 6324439 B1
- EP 0454100 A2
- US 6221794 B1

**In der Beschreibung aufgeführte Nicht-Patentliteratur**

- **Odekirk et al.** *Proceedings of the Symposium on Dielectric Films on Compound Semiconductors,* 14. Oktober 1985, 274-286